# EUROPEAN PATENT APPLICATION

(11) **EP 4 552 796 A1**
(43) Date of publication of application: **14.05.2025**
(21) Application number: 22940504.8
(22) Date of filing: 11.08.2022
(51) Int. Cl.: B24B 37/20, B24B 37/22, B24B 37/24, B24D 11/00, H01L 21/67

(54) **POLISHING PAD EQUIPPED WITH WINDOW AND METHOD FOR MANUFACTURING SAME**

(30) Priority: 06.07.2022 KR 20220083351
(71) Applicant: KPX Chemical Co., Ltd., Seoul 04143 (KR)
(72) Inventor: MIN, Byung Ju, Incheon 22734 (KR); HONG, Seok Ji, Hwaseong-si Gyeonggi-do 18444 (KR); KANG, Hak Su, Hwaseong-si Gyeonggi-do 18475 (KR); JUNG, Dae Han, Hwaseong-si Gyeonggi-do 18444 (KR); PARK, Gi Young, Hwaseong-si Gyeonggi-do 18499 (KR); JANG, Hyun Il, Hwaseong-si Gyeonggi-do 18450 (KR)
(74) Representative: dompatent von Kreisler Selting Werner - Partnerschaft von Patent- und Rechtsanwälten mbB
(86) International application number: PCT/KR2022/012019
(87) International publication number: WO 2024/010132

(57) **Abstract**

Disclosed are a window-mounted polishing pad in which since a thermal fusion method and a vibration fusion method are not applied while the window is inserted into and attached to the polishing pad, the polishing pad is not deformed and polishing slurry does not leak through a gap between the window and the polishing pad, and a method of manufacturing the same. The window-mounted polishing pad includes: a polishing layer in which a first punched hole is formed in a thickness direction; a window that is inserted into and fixed to the first punched hole of the polishing layer; a lower support layer that is positioned below the polishing layer and the window and has a second punched hole for irradiating an optical beam formed at a lower end side of the window and having a narrower width than the first punched hole or the window; an adhesive layer that mediates bonding of the polishing layer and the lower support layer, has the same area as the lower support layer, and partially overlaps but does not contact an edge portion of the window; and a sealing adhesive member positioned between the window and the adhesive layer.

## Description

### [Technical Field]

This application claims the benefit of priority based on Korean Patent Application No. 10-2022-0083351 filed on July 6, 2022, the entire contents of which are incorporated as part of the present specification.

The present invention relates to a window-mounted polishing pad used to chemically and mechanically planarize a semiconductor wafer and a method of manufacturing the same, and more particularly, to a window-mounted polishing pad in which since a thermal fusion method and a vibration fusion method are not applied while the window is inserted into and attached to the polishing pad, the polishing pad is not deformed and polishing slurry does not leak through a gap between the window and the polishing pad, and a method of manufacturing the same.

### [Background Art]

A chemical mechanical planarization/polishing (hereinafter referred to as CMP) process is a process introduced for global planarization of semiconductor devices, and is emerging as a more important process in accordance with the trend of, in particular, a larger diameter of a semiconductor wafer, higher integration, miniaturization of a line width, and multi-layering of a wiring structure.

In the CMP process, polishing speed and planarization are important, and are determined by process conditions of polishing equipment and polishing slurry and a polishing pad that are consumable members. Among these, polishing slurry performs a function of chemically removing a wafer film quality through chemical components in a slurry solution. In addition, a polishing pad performs a role of uniformly distributing the polishing slurry on the wafer while contacting a surface of the wafer, and at the same time physically removing the wafer film quality through polishing particles included in the slurry solution and protrusions positioned on the surface of the polishing pad.

In addition, in the recent CMP process, a polishing pad inserted into and attached to a window is used to detect a polishing end point of the wafer. In addition, the detection is performed by transmitting an optical beam, such as a laser beam, through the window in the polishing pad, so a thickness of the wafer during the polishing process may be analyzed.

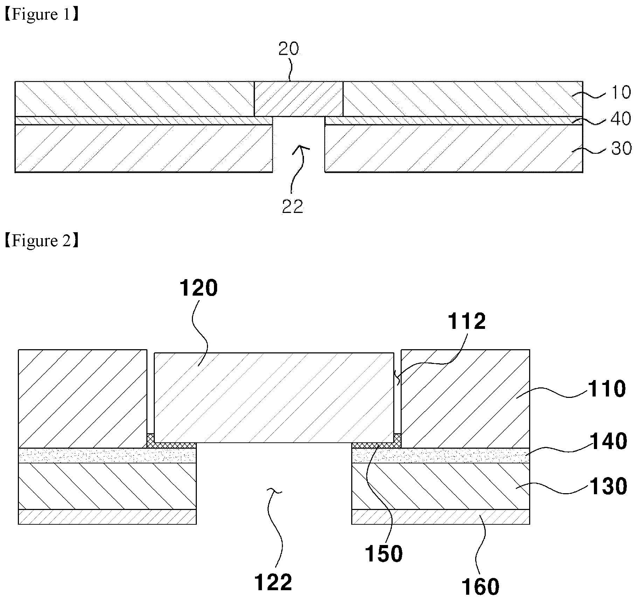

FIG. 1 is a schematic side cross-sectional view of a typical window-mounted polishing pad. As shown in FIG. 1, the typical window-mounted polishing pad includes a polishing layer 10 in which a punched hole is formed in a thickness direction, a window 20 that is inserted into and fixed to the punched hole of the polishing layer 10, a lower support layer 30 that is positioned below the polishing layer 10 and the window 20 and has an opening 22 for transmitting an optical beam formed at a lower end side of the window 20 and having a width narrower than that of the window 20, and an adhesive layer 40 that bonds each of the polishing layer 10 and the window 20 to the lower support layer 30.

In this way, the typical window-mounted polishing pad uses a portion of the adhesive layer 40 interposed between a portion of a lower surface of the window 20 and the lower support layer 30 to attach the window 20 to the polishing pad. In addition, the adhesive layer 40 is formed by a thermal fusion method after applying a hot melt adhesive (for example, a melting point of 90°C to 130°C) between a portion of the lower surface of the window 20 and the lower support layer 30.

However, when the thermal fusion method is used to attach the window 20 into the polishing pad, high-temperature heat energy is transmitted to the polishing layer 10 of the polishing pad, thereby causing dimensional deformation problems such as contraction or expansion of the polishing pad. In addition, since there is no separate sealing means, during the CMP process, the polishing slurry sequentially penetrates into 'a gap between the polishing layer 10 and the window 20' and 'a gap between the window 20 and the adhesive layer 40 (or the lower support layer 30)', thereby inevitably causing the problem of liquid leaking down the lower support layer 30. That is, since the CMP process is a harsh process in which external force is applied physically and chemically in a high temperature and humidity environment, the window 20 is repeatedly contracted and expanded during the CMP process, and the adhesive 40 falls off or forms the gap, so the polishing slurry may leak. Therefore, there is a limit to preventing the polishing slurry from leaking only by the adhesive layer 40.

Therefore, when the window may be attached to the polishing pad while preventing problems of dimensional deformation of the polishing pad and leakage of the polishing slurry toward the bottom of the lower support layer, it is expected to become a new driving force in polishing a semiconductor wafer.

### [Disclosure]

### [Technical Problem]

The present invention provides a window-mounted polishing pad in which since a thermal fusion method and a vibration fusion method are not applied while the window is inserted into and attached to the polishing pad, the polishing pad is not deformed and polishing slurry does not leak through a gap between the window and the polishing pad, and a method of manufacturing the same.

### [Technical Solution]

To achieve the object, the present invention provides a window-mounted polishing pad, including: a polishing layer in which a first punched hole is formed in a thickness direction; a window that is inserted into and fixed to the first punched hole of the polishing layer; a lower support layer that is positioned below the polishing layer and the window and has a second punched hole for irradiating an optical beam formed at a lower end side of the window and having a narrower width than the first punched hole or the window; an adhesive layer that mediates bonding of the polishing layer and the lower support layer, has the same area as the lower support layer, and partially overlaps but does not contact an edge portion of the window; and a sealing adhesive member positioned between the window and the adhesive layer.

In addition, the present invention provides a method of manufacturing a window-mounted polishing pad, including: a) forming a first punched hole penetrating in a thickness direction on one end of a polishing member; b) attaching a support member to a lower end surface of the polishing member using a first adhesive to form a structure in which a lower support layer, an adhesive layer, and a polishing layer are sequentially stacked; c) forming a second punched hole penetrating each other with the first punched hole of the polishing layer by punching the lower support layer and the adhesive layer of an area corresponding to the first punched hole of the polishing layer to a width narrower than the first punched hole; d) applying a second adhesive to an upper end surface of the adhesive layer exposed to an outside of the first punched hole and then inserting a window into the first punched hole; and e) compressing the window inserted into the first punched hole so that the window is fixed through a second adhesive.

### [Advantageous Effects]

According to a window-mounted polishing pad and a method of manufacturing the same of the present invention, since a thermal fusion method and a vibration fusion method are not applied while the window is inserted into and attached to the polishing pad, the polishing pad is not deformed and polishing slurry does not leak through a gap between the window and the polishing pad.

### [Description of Drawings]

FIG. 1 is a schematic side cross-sectional view of a typical window-mounted polishing pad.
FIG. 2 is a schematic side cross-sectional view of the window-mounted polishing pad according to the embodiment of the present invention.
FIG. 3 is an image sequentially showing an appearance in which the window-mounted polishing pad according to the embodiment of the present invention is manufactured.

### [Best Mode]

Hereinafter, the present invention will be described in detail with reference to the accompanying drawings.

FIG. 2 is a schematic side cross-sectional view of the window-mounted polishing pad according to the embodiment of the present invention. As illustrated in FIG. 2, the window-mounted polishing pad according to the present invention includes: a polishing layer 110 in which a first punched hole 112 is formed in a thickness direction; a window 120 that is inserted into and fixed to the first punched hole 112 of the polishing layer 110; a lower support layer 130 that is positioned below the polishing layer 110 and the window 120 and has a second punched hole 122 for irradiating an optical beam formed at a lower end side of the window 120 and having a narrower width than the first punched hole 112 or the window 120; an adhesive layer 140 that mediates bonding of the polishing layer 110 and the lower support layer 130, has the same area as the lower support layer 130, and partially overlaps but does not contact an edge portion of the window 120; and a sealing adhesive member positioned between the window 120 and the adhesive layer 140.

In accordance with the trend of a larger diameter of a wafer, higher integration, miniaturization of a line width, and multi-layering of a wiring structure, in a chemical mechanical planarization/polishing (hereinafter referred to as CMP) process, a polishing speed and planarization are important. The polishing speed and planarization are important and are determined by process conditions of polishing equipment and polishing slurry and a polishing pad that are consumable members. In particular, the polishing pad performs a role of uniformly dispersing the polishing slurry on the wafer while contacting a surface of the wafer, and at the same time, physically removing the wafer film quality through the polishing particles included in the slurry solution and the protrusions positioned on the surface of the polishing pad. Recently, after the window is mounted on such a polishing pad, an optical beam may be transmitted to detect the polishing end point of the wafer and analyze the wafer thickness during the polishing process.

However, since the typical polishing pad with a window is heat-fused or vibration-fused when the window is attached, dimensional deformation problems, such as contraction or expansion of the polishing pad, occur. In addition, the typical window-mounted polishing pad does not have a separate sealing means, so a problem occurs in which the polishing slurry leaks into a gap between the window and the polishing pad facing the window during the CMP process. Accordingly, the present applicant has invented a window-mounted polishing pad that prevents problems of the dimensional deformation of the polishing pad and leakage of the polishing slurry.

First, the polishing layer 110 may be a foam having micropores. In addition, the foam may include one or more selected from the group consisting of a polyurethane-based resin, a polyester-based resin, a polyamide-based resin, an acrylic resin, a polycarbonate-based resin, a polyolefin-based resin, and an epoxy-based resin. It may be preferable that the polishing layer 110 is made of the foam including the polyurethane-based resin, that is, the polyurethane-based foam. An average diameter of pores of the polishing layer 110 or the foam may be 5 to 100 µm, and a porosity of the polishing layer 110 or the foam may be 20 to 70% by volume, but are not limited thereto.

The surface of the polishing layer 110 may have a concavo-convex structure with alternating reliefs and engravings in order to achieve the original purpose of the polishing layer (acting as a flow channel for the polishing slurry), and may be formed with a groove having a pitch, width, depth, etc., of a specific shape at a specific position. In addition, the thickness of the polishing layer 110 may be, for example, 1.5 to 2.5 mm, but there is no particular limitation on the thickness, as it may vary depending on the thickness of the polishing object (semiconductor wafer) or the process conditions, etc.

In this polishing layer 110, the first punched hole (or first punched area, 112) is formed in the thickness direction. There is no particular limitation on the shape of the first punched hole 112, and examples may include a circle, an oval, a square, and a polygon based on the planar shape (shape viewed from above). In addition, there is no particular limitation on the size (area or volume) of the first punched hole 112, and the first punched hole 112 may be formed in any size as long as optical beams can transmit therethrough. In addition, there is no particular limitation on the position of the first punched hole 112, and the polishing layer 110 may be positioned anywhere as long as the thickness, etc., of the wafer, etc., may be measured using an optical beam.

Next, the window 120 is inserted into and fix to the first punched hole 112 of the polishing layer 110, and the upper surface position in the inserted and fixed state may be the same as the upper surface position of the polishing layer 110 or may be lower than the position of the upper surface of the polishing layer 110 (that is, in the latter case, the portion where the window is inserted may be in a depressed form). On the other hand, when the window 120 protrudes beyond the polishing layer 110, not only may it affect the polishing of the wafer, but also scratches or cracks may occur on the upper surface of the window 120, making it easier for the optical beam to pass through. Therefore, it is not preferable for the window 120 to protrude beyond the polishing layer 110.

The window 120 may include a common material used in the art as a window material for a polishing pad. However, applying a window for a polishing pad disclosed in Korean Patent Application No. 10-2022-0008594 (Invention Title: Method for manufacturing a window for polishing pad and window for polishing pad manufactured by the same) filed by the present applicant on January 20, 2022 may be desirable in terms of transmittance and reliability of polishing end point detection. In addition, in order to prevent the polishing slurry from leaking into the lower portion of the window 120, it may also be preferable to use a non-foam material without pores as a material for the window 120.

In addition, since the window 120 should be inserted into the first punched hole 112 of the polishing layer 110 described above, the window 120 should have an area equal to or slightly smaller than that of the first punched hole 112. However, when the area of the window 120 is the same as the area of the first punched hole 112, the insertion into the first punched hole 112 is not smooth, resulting in damage to the polishing layer 110 or the window 120 itself. Accordingly, it may be desirable that the area of the window 120 is slightly smaller than that of the first punched hole 112.

Subsequently, the lower support layer 130 is positioned at the lower end of the polishing layer 110 and is positioned to overlap a portion of the lower end of the window 120, and serves to support the polishing layer 110 and at the same time absorb and disperse the impact applied to the polishing layer 110. The lower support layer 130 may include, but is not limited to, a material selected from the group consisting of, for example, a non-woven fabric impregnated with a polyurethane resin, polyurethane foams, and suedes of a polyurethane resin. In addition, the thickness of the lower support layer 130 may be, for example, 0.4 to 1.5 mm, but there is no particular limitation on the thickness, as it may vary depending on the thickness of the polishing layer 110 or the process conditions, etc.

In the lower support layer 130, the second punched hole 122 (or a second punched hole 122) is in a thickness direction. Accordingly, the second punched hole 122 is formed with a narrower width than the first punched hole 112 or the window 120 so that the optical beam irradiates and transmits toward the window 120. In other words, the second punched hole 122 is formed below the first punched hole 112 and is formed to be smaller than the planar area of the first punched hole 112, so the first punched hole 112 and the second punched hole 122 are connected to penetrate each other. Meanwhile, when the planar area of the second punched hole 122 is greater than or equal to that of the first punched hole 112, there may be the problem in that the window 120 inserted into the first punched hole 112 is not fixed and deviates downward. Therefore, the planar area of the second punched hole 122 should be smaller than that of the first punched hole 112 (that is, the lower support layer also serves as a latch to prevent the window from deviating). In addition, there is no particular limitation on the shape of the second punched hole 122, and examples may include a circle, an oval, a square, and a polygon based on the planar shape (shape viewed from above).

Subsequently, the adhesive layer 140 serves as a mediator for bonding the polishing layer 110 and the lower support layer 130, and is positioned to face the entire upper surface of the lower support layer 130, so the adhesive layer 140 has the same area as the lower support layer 130. Accordingly, like the lower support layer 130, the adhesive layer 140 partially overlaps with the edge portion of the window 120 but does not contact the edge portion of the window 120.

The adhesive layer 140 may include, for example, one or more selected from the group consisting of a polyurethane-based resin, a polyester-based resin, an ethylene-vinyl acetate-based resin, a polyamide-based resin, and a polyolefin-based resin, and may be preferable to include at least one of a urethane-based resin and a polyester-based resin.

Lastly, the sealing adhesive member 150 is a core component of the present invention, and is positioned between the window 120 and the adhesive layer 140 to serve to bond them, and at the same time, serves to prevent slurry from penetrating and leaking into the inside and lower portion of the polishing pad during the polishing process.

Meanwhile, as described above, in order to insert the window 120 into the first punched hole 112 of the polishing layer 110 without damage, the area of the window 120 must be slightly smaller than the area of the first punched hole 112. Accordingly, a fine gap inevitably occurs between the wall surface of the first punched hole 112 and the window 120. Therefore, for the purpose of more fundamentally preventing slurry penetration and leakage, the sealing adhesive member 150 is also formed in the separation space formed between the wall of the first punched hole 112 and the window 120. In this case, as illustrated in FIG. 2, the sealing adhesive member 150 may be continuously connected from the separation space formed between the wall surface of the first punched hole 112 and the window 120 to the space between the window 120 and the adhesive layer 140 to form a right angle shape.

Such a sealing adhesive member 150 may include a cured liquid adhesive. For example, the liquid adhesive may include one or more selected from the group consisting of vinyl acetate-based compounds, polychloroprene-based compounds, polyurethane-based compounds, acrylate-based compounds such as cyanoacrylate, and epoxy-based compounds. The sealing adhesive member 150 is provided without heat melting.

Meanwhile, the window-mounted polishing pad according to the present invention further includes a tape layer 160 that is entirely attached to the lower surface of the lower support layer 130, if necessary. The tape layer 160 serves to adhere and fix the polishing pad to a platen, and as the tape layer 160, any material that can adhere and fix the polishing pad and the platen to each other, such as a double-sided adhesive tape, can be used without particular restrictions.

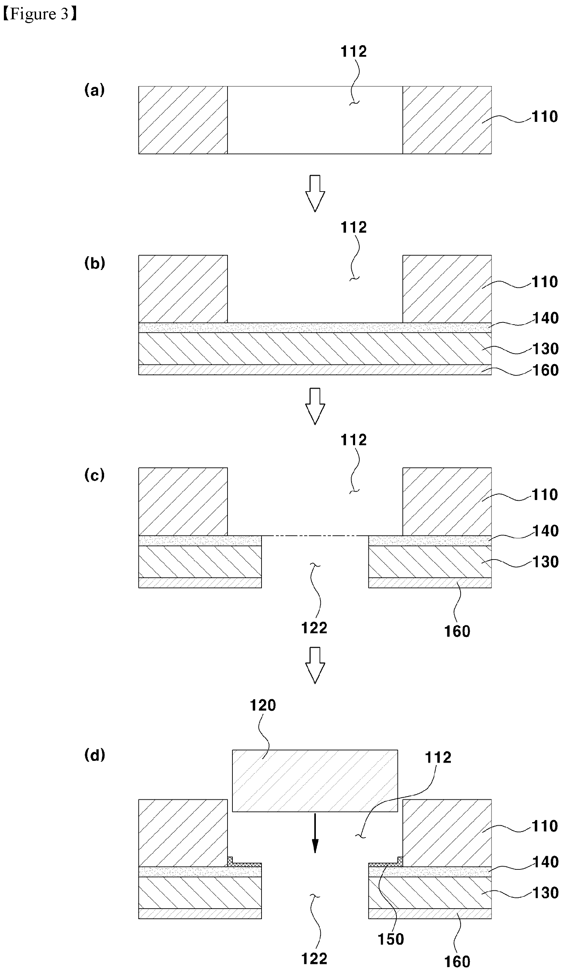

Next, a method of manufacturing a window-mounted pad according to the present invention will be described. FIG. 3 is an image sequentially showing an appearance in which the window-mounted polishing pad according to the embodiment of the present invention is manufactured. Referring to FIG. 3, a method of manufacturing a window-mounted polishing pad includes: a) forming a first punched hole 112 penetrating in a thickness direction on one end of a polishing member 110; b) attaching a support member 130 to a lower end surface of the polishing member 110 using a first adhesive 140 to form a structure in which a lower support layer 130, an adhesive layer 140, and a polishing layer 110 are sequentially stacked; c) forming a second punched hole 122 penetrating each other with the first punched hole 112 of the polishing layer 110 by punching the lower support layer 130 and the adhesive layer 140 of an area corresponding to the first punched hole 112 of the polishing layer 110 to a width narrower than the first punched hole 112; d) applying a second adhesive 150 to an upper end surface of the adhesive layer 140 exposed to an outside of the first punched hole 112 and then inserting a window 120 into the first punched hole 112; and e) compressing the window 120 inserted into the first punched hole 112 so that the window is fixed through a second adhesive 150.

A process of forming a first punched hole 112 in the polishing member 110 in step a) above, and a process of forming a second punched hole 122 in the lower support layer 130 and the adhesive layer 140 in step c) above may be performed through a press method using a cutting tool, but is not limited thereto. Meanwhile, the polishing member is the same as the polishing layer 110 described above, and it is noted that the above terms are used considering that this is before forming the layer.

Step b) above is a step of attaching the support member 130 to the lower end surface of the polishing member 110 through the first adhesive 140. In this case, in the state in which the first adhesive 140 may first be separately heated and melted (90°C to 130°C) and then is applied to one surface of the support member 130, the support member 130 may be bonded to the lower end surface of the polishing member 110, or after the first adhesive 140 is heated and melted in a state in which the first adhesive 140 is applied to one surface of the support member 130, the support member 130 may be bonded to the lower end surface of the polishing member 110. Meanwhile, the support member is the same as the lower support layer 130 described above, and it is noted that the above terms are used considering that this is before forming the layer.

The second adhesive is the same as the sealing adhesive member 150 described above, and therefore, the second adhesive 150 is a liquid adhesive. In step d) above, the second adhesive 150 is applied only to the upper end surface of the adhesive layer 140 exposed to the outside of the first punched hole 112, but in order to fundamentally prevent slurry penetration and leakage, the second adhesive 150 may also be applied to the wall surface of the first punched hole 112. In addition, the compression in step e) above may be performed under temperature conditions of 10°C to 70°C, and preferably 10°C to 40°C. As such, the present invention completely excludes the thermal fusion method in attaching the window 120 to the polishing pad (i.e., the second adhesive is not heated and melted in steps d) to e) above. As a result, compared to the method of attaching a window using the existing thermal fusion method or vibration fusion method, the problem of dimensional deformation of the polishing pad (specifically, the polishing layer) may be prevented or minimized.

Meanwhile, the method of manufacturing a window-mounted polishing pad according to the present invention further includes a step of attaching the tape 160 to the lower end surface of the support member 130 (i.e., the surface to which the first adhesive is not applied), if necessary. This may be performed in any step of the above manufacturing method, but it may be preferable in terms of convenience to attach the tape 160 before step c) above (i.e., forming the second punched hole) is performed.

Hereinafter, the present invention will be described in more detail with reference to detailed Examples. The following Examples are intended to illustrate the present invention, but the present invention is not limited to the following Examples.

### [Example 1] Manufacturing of window-mounted polishing pad

First, a structure in which a lower support layer, an adhesive layer, and polishing layer are sequentially stacked was manufactured by forming a first punched hole (planar shape: rectangular, planar area: 20 mm × 60 mm) penetrating in a thickness direction on one end of a polishing member (thickness: 2 mm) made of a polyurethane foam, and then attaching a support member (nonwoven fabric impregnated with polyurethane resin, thickness: 0.8 mm) to a lower end surface of the polishing member through a first adhesive (polyurethane-based resin). At this time, the first adhesive is melted at a temperature of 110°C to attach the polishing member and the support member.

Next, the first punched hole and a second punched hole (planar shape: rectangular, planar area: 13 mm × 50 mm) of the polishing layer penetrating through each other were formed by punching the lower support layer and the adhesive layer of an area corresponding to the first punched hole of the polishing layer to a width narrower than the first punched hole.

Subsequently, a second adhesive (cyanoacrylic resin) was applied to the upper end surface of the adhesive layer exposed to the outside of the first punched hole, and then a window (non-foam made of polyurethane) was inserted into the first punched hole. Finally, the window-mounted polishing pad was manufactured by compressing under a temperature condition of 30°C so that the window inserted into the first punched hole was fixed with a second adhesive.

### [Comparative Example 1] Manufacturing of window-mounted polishing pad

A window-mounted polishing pad was manufactured in the same manner as in Example 1, except that the window was attached with the first adhesive without using the second adhesive and the window was attached by melting the first adhesive at a temperature of 110°C (additionally melted separately from melting when manufacturing the stacked structure).

### [Experimental Example 1] Evaluation of Degree of Dimensional Deformation of Polishing Pad

The dimension of the polishing layer of the polishing pad manufactured in Example 1 was compared and contrasted with the dimension of the polishing layer of the polishing pad manufactured in Comparative Example 1, and how much each window was deformed compared to its dimension before the window is mounted was measured. The results were shown in Table 1 below.

**[Table 1]**

| | Example 1 | | Comparative Example 1 | |
|---|---|---|---|---|
| | Before window is mounted | After window is mounted | Before window is mounted | After window is mounted |
| Dimension of Polishing layer (Window mounting part) | 2.20 mm | 2.20 mm | 2.20 mm | 2.24 mm |

As a result of the measurement, as shown in Table 1 above, the polishing pad (polishing layer) of Example 1 to which the window was attached without thermal fusion was the same as the dimension before the window is attached, so it was identified that there was no dimensional deformation of the polishing pad. On the other hand, it was confirmed that the polishing pad (polishing layer) of Comparative Example 1, to which the window was attached through thermal fusion, was stretched beyond its size before the window was attached, so it may be confirmed that expansion occurred due to thermal fusion.

### [Experimental Example 2] Evaluation of Leakage of Polishing Slurry

The semiconductor wafers were disposed to be in contact with the surfaces of the polishing pad manufactured in Example 1 and Comparative Example 1, and CMP slurry was injected thereon and the polishing pad was rotated. At the same time, it was observed whether the slurry leaks to the lower portion of the polishing pad.

As a result of the observation, when the polishing pad of Example 1, in which the sealing adhesive member (second adhesive) was positioned between the adhesive layer and the window, was used, no slurry leakage to the lower portion of the polishing pad occurred at all. On the other hand, when the polishing pad of Comparative Example 1 with the adhesive layer and window attached without the sealing adhesive member (second adhesive) was used, it was identified that the slurry leaks to the lower part of the polishing pad.

### [Description of Reference Signs]

10, 110: Polishing layer
112: First punched hole
20, 120: Window
22, 122: Second punched hole
30, 130: Lower support layer
40, 140: Adhesive layer
150: Sealing adhesive member
160: Tape layer

## Claims

1. A window-mounted polishing pad, comprising:
a polishing layer in which a first punched hole is formed in a thickness direction;
a window that is inserted into and fixed to the first punched hole of the polishing layer;
a lower support layer that is positioned below the polishing layer and the window and has a second punched hole for irradiating an optical beam formed at a lower end side of the window and having a narrower width than the first punched hole or the window;
an adhesive layer that mediates bonding of the polishing layer and the lower support layer, has the same area as the lower support layer, and partially overlaps but does not contact an edge portion of the window; and
a sealing adhesive member positioned between the window and the adhesive layer.

2. The polishing pad according to claim 1, wherein the sealing adhesive member is formed even in a separation space formed between a wall surface of the first punched hole and the window.

3. The polishing pad according to claim 2, wherein the sealing adhesive member forms a right angle shape by continuously extending from the separation space formed between the wall surface of the first punched hole and the window to a space between the window and the adhesive layer.

4. The polishing pad according to claim 1, wherein the sealing adhesive member comprises a cured liquid adhesive.

5. The polishing pad according to claim 4, wherein the liquid adhesive comprises at least one selected from the group consisting of a vinyl acetate-based compound, a polychloroprene-based compound, a polyurethane-based compound, an acrylate-based compound, and an epoxy-based compound.

6. The polishing pad according to claim 1, wherein the sealing adhesive member is provided without heat melting.

7. A method of manufacturing a window-mounted polishing pad, comprising:
a) forming a first punched hole penetrating in a thickness direction on one end of a polishing member;
b) attaching a support member to a lower end surface of the polishing member using a first adhesive to form a structure in which a lower support layer, an adhesive layer, and a polishing layer are sequentially stacked;
c) forming a second punched hole penetrating each other with the first punched hole of the polishing layer by punching the lower support layer and the adhesive layer of an area corresponding to the first punched hole of the polishing layer to a width narrower than the first punched hole;
d) applying a second adhesive to an upper end surface of the adhesive layer exposed to an outside of the first punched hole and then inserting a window into the first punched hole; and
e) compressing the window inserted into the first punched hole so that the window is fixed through a second adhesive.

8. The method according to claim 7, wherein the second adhesive is also applied to a wall surface of the first punched hole.

9. The method according to claim 7, wherein in steps d) to e) above, the second adhesive is not heated or melted.

10. The method according to claim 7, wherein the second adhesive comprises at least one selected from the group consisting of a vinyl acetate-based compound, a polychloroprene-based compound, a polyurethane-based compound, an acrylate-based compound, and an epoxy-based compound.
